Europäisches Patentamt

European Patent Office

Office européen des brevets

(11) Numéro de publication : **0 310 490 B1**

## FASCICULE DE BREVET EUROPEEN

(45) Date de publication du fascicule du brevet :
19.07.95 Bulletin 95/29

(51) Int. Cl.⁶ : **H03L 1/02, H03B 5/04**

(21) Numéro de dépôt : **88402430.8**

(22) Date de dépôt : **27.09.88**

(54) **Oscillateur piézoélectrique compensé en température.**

(30) Priorité : **29.09.87 FR 8713454**

(43) Date de publication de la demande :
**05.04.89 Bulletin 89/14**

(45) Mention de la délivrance du brevet :
**19.07.95 Bulletin 95/29**

(84) Etats contractants désignés :
**CH DE FR GB IT LI NL SE**

(56) Documents cités :
**FR-A- 2 284 219
GB-A- 2 038 125**

(73) Titulaire : **COMPAGNIE D'ELECTRONIQUE ET
DE PIEZO-ELECTRICITE - C.E.P.E.
44, avenue de la Glacière
F-95100 Argenteuil (FR)**

(72) Inventeur : **Marotel, Gérard
Thomson-CSF
SCPI-19, avenue de Messine
F-75008 Paris (FR)**

(74) Mandataire : **Guérin, Michel et al
THOMSON-CSF
SCPI
B.P. 329
50, rue Jean-Pierre Timbaud
F-92402 Courbevoie Cédex (FR)**

EP 0 310 490 B1

## Description

La présente invention concerne les oscillateurs piézoélectriques compensés en température, c'est-à-dire les oscillateurs piézoélectriques comportant une régulation de fréquence en fonction de la température.

Les oscillateurs compensés en température sont constitués, comme les oscillateurs piézoélectriques classiques, d'un amplificateur dont la sortie est connectée à l'entrée à travers un circuit comprenant un cristal piézoélectrique oscillant, le gain du système étant supérieur à l'unité pour satisfaire les conditions d'auto-oscillation. Dans ce cas, la compensation en fréquence est obtenue en connectant en série avec le cristal piézoélectrique un élément qui présente une capacité variable en fonction de la tension électrique appliquée à ses bornes tel qu'une diode à capacité variable et en créant la tension électrique à appliquer sur la diode à capacité variable ou tension de compensation dans un circuit de compensation comprenant un élément sensible à la température.

Les systèmes de compensation en température permettent d'obtenir une fréquence pratiquement stable quelle que soit la température en sortie de l'oscillateur. Cependant, les oscillateurs piézoélectriques sont soumis à un phénomène de vieillissement, c'est-à-dire que leur fréquence d'oscillation évolue avec le temps. Il est donc nécessaire de réaliser un recalage de l'oscillateur en fonction du temps. Ce recalage consiste à modifier l'impédance en série avec le cristal piézoélectrique de façon à obtenir la fréquence nominale de l'oscillateur. Dans le cas d'utilisation de diodes à capacité variable, le recalage consiste à modifier la tension à ses bornes. Or, ce recalage modifie la compensation en température.

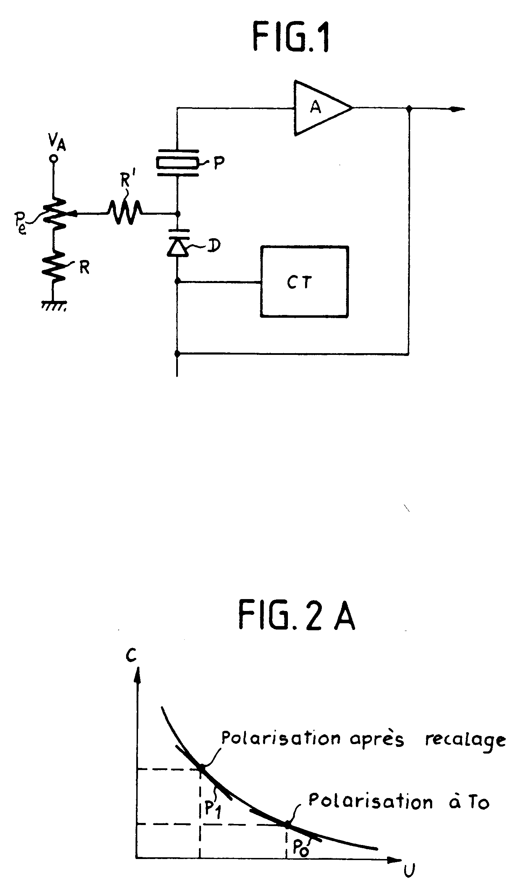

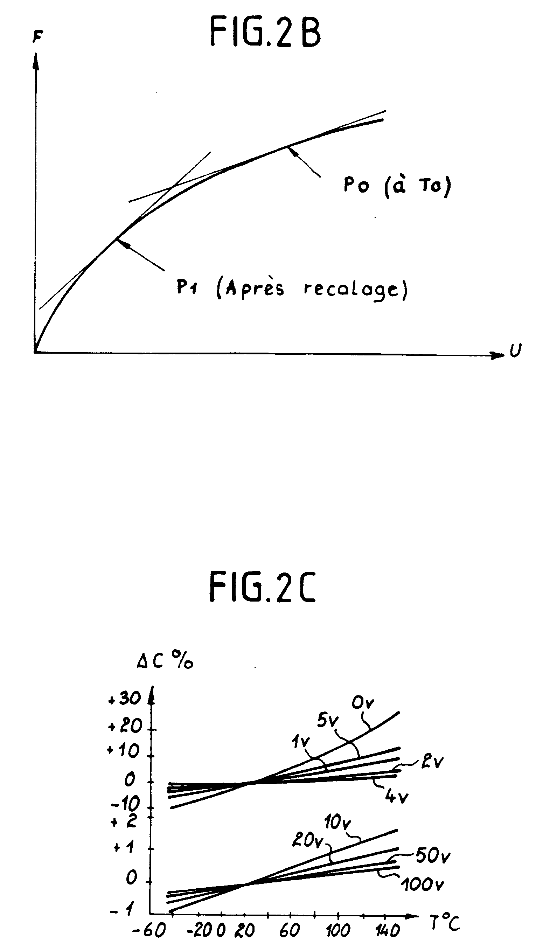

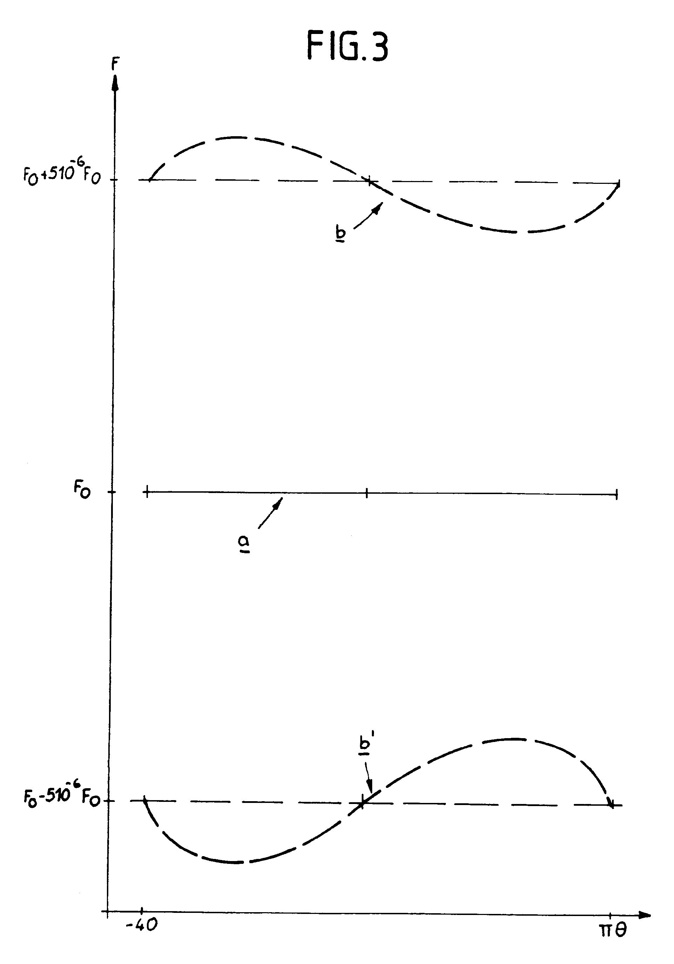

En effet, comme représenté schématiquement sur la figure 1, un mode de réalisation d'un circuit de recalage utilisé dans un oscillateur piézoélectrique compensé en température est constitué par un potentiomètre Pe monté en série entre la tension d'alimentation $V_A$ et une borne d'une résistance R dont l'autre borne est à la masse. La borne milieu du potentiomètre Pe est connectée par l'intermédiaire d'une résistance R' sur la cathode de la diode à capacité variable D. D'autre part, dans le mode de réalisation représenté, l'anode de la diode à capacité variable D est connectée au circuit CT de régulation de fréquence en fonction de la température. De manière connue, la diode à capacité variable est montée en série avec le cristal piézoélectrique P et l'amplificateur A dont la sortie est rebouclée sur l'anode de la diode à capacité variable D. Ainsi, lorsque l'on fait varier le potentiomètre pour réaliser le recalage en fréquence de l'oscillateur, on modifie la tension de polarisation de la diode à capacité variable. Or, comme représenté sur les figures 2A et 2B, la caractéristique capacité/tension d'une diode à capacité variable ne permet pas d'obtenir une variation de fréquence linéaire en fonction de sa tension de polarisation. Il en résulte donc une modification de la pente P0 de la fonction de transfert qui devient la pente P1. Cette modification de la pente se traduit par une rotation de la courbe de compensation comme représenté sur la figure 3 concernant un recalage de fréquence de $\pm 5.10^{-6}$ de la fréquence nominale F0. De plus, le coefficient de température des diodes à capacité variable varie en fonction de la tension de polarisation (figure 2C), ce qui accentue l'effet de rotation de la courbe de compensation.

Sur cette figure, la droite $\underline{a}$ à F0 représente la compensation idéale au temps $\overline{T0}$, les courbes $\underline{b}$ et $\underline{b}'$ représentent la fréquence issue de l'oscillateur après recalage positif ou négatif pour une dérive en fréquence de $\pm 5.10^{-6}$ F0. Cette distorsion de la courbe de compensation présente de nombreux inconvénients. Notamment, l'oscillateur peut être amené à sortir des caractéristiques imposées par la spécification.

La présente invention a donc pour but de remédier à ces inconvénients et elle a pour objet un oscillateur piézoélectrique tel que défini dans la revendication 1.

On connait par la demande de brevet anglais GB-A-2038 125 un oscillateur à cristal compensé en température comportant un amplificateur dont la sortie est rebouclée sur l'entrée à travers du cristal monté en série avec un élément a capacité variable.

Un circuit de régulation de la fréquence en fonction de la température est connecté en entrée d'un amplificateur opérationnel à gain variable au moyen d'une résistance réglable montée dans une boucle de contre-réaction. La sortie de l'amplificateur est connectée sur l'une des bornes de l'élément à capacité variable.

La présente invention a pour objet un oscillateur piézoélectrique compensé en température dont l'évolution de sa fréquence engendrée par son vieillissement est limitée. Il comporte un circuit oscillant constitué d'un amplificateur dont la sortie est rebouclée sur l'entrée à travers un cristal piézoélectrique monté en série avec un élément à capacité variable, un circuit de régulation de la fréquence en fonction de la température, délivrant une tension de compensation, connecté sur une première entrée d'un amplificateur opérationnel à résistance de contre-réaction ayant un gain variable au moyen d'une résistance réglable. Sa sortie est connectée sur une borne de l'élément à capacité variable.

L'amplificateur opérationnel reçoit sur une deuxième entrée une tension de recalage délivrée par un circuit de rattrapage en fréquence comportant la résistance réglable. Le réglage de la résistance réglable vise a modifier d'une part la tension de recalage et d'autre part le gain de l'amplificateur opérationnel.

Selon un mode de réalisation préférentiel, l'amplificateur opérationnel reçoit sur son entrée inverseuse la tension de recalage et sur son entrée non-inverseuse la tension de compensation .

D'autres caractéristiques et avantages de la présente invention apparaîtront à la lecture de la description d'un mode de réalisation faite ci-après avec référence aux dessins ci-annexés dans lesquels :

- la figure 1, déjà décrite, est une représentation schématique d'un oscillateur compensé en température selon l'art antérieur ;
- la figure 2A, déjà décrite, représente la caractéristique capacité/tension d'une diode à capacité variable;
- la figure 2B, déjà décrite, représente la caractéristique fréquence/tension de l'oscillateur ;
- la figure 2C, déjà décrite, représente la variation du coefficient de température d'une diode à capacité variable en fonction de sa tension de polarisation ;
- la figure 3, déjà décrite, représente la courbe de compensation de la fréquence en fonction de la température au temps T0 et après un vieillissement à long terme, obtenue avec l'oscillateur de la figure 1;
- la figure 4 est une représentation schématique d'un oscillateur compensé en température conformément à la présente invention ;
- la figure 5 représente la courbe de compensation de la fréquence en fonction de la température obtenue avec l'oscillateur de la présente invention.

Pour simplifier la description, dans les figures les mêmes éléments portent les mêmes références.

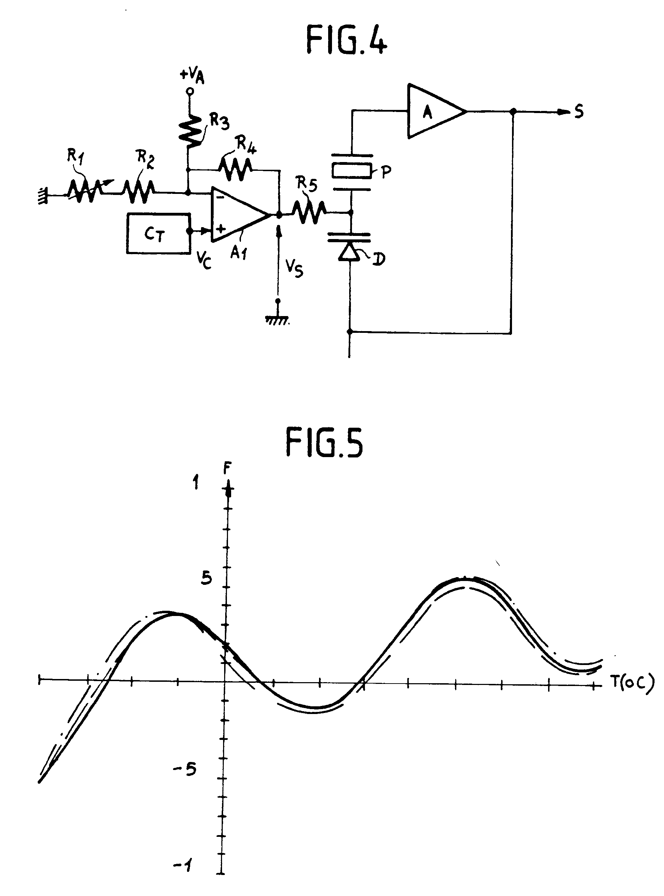

Sur la figure 4 on a représenté un oscillateur compensé en température conforme à la présente invention. Cet oscillateur comporte de manière connue un amplificateur A dont la sortie S est rebouclée sur l'entrée par l'intermédiaire d'un résonateur piézoélectrique P monté en série avec une diode à capacité variable D. Conformément à la présente invention, une tension de compensation en température $V_c$ est appliquée sur la cathode de la diode à capacité variable par l'intermédiaire d'un moyen dont le gain varie en fonction de la tension de recalage qui est variable au cours du temps. De manière plus spécifique, ce moyen comporte un amplificateur opérationnel A1 dont l'entrée non-inverseuse reçoit la tension de compensation $V_C$ issue du circuit CT de régulation de fréquence en fonction de la température. D'autre part, son entrée inverseuse reçoit une tension fonction du recalage donné. Cette tension est donnée par un pont diviseur. Ainsi, l'entrée inverseuse est connectée par l'intermédiaire de la résistance $R_3$ à la tension d'alimentation $V_A$. Cette entrée inverseuse est aussi connectée à la masse par l'intermédiaire de la résistance $R_2$ et d'une résistance variable $R_1$. L'amplificateur opérationnel $A_1$ comporte de plus une résistance de contre réaction $R_4$ montée entre sa sortie et son entrée inverseuse. De plus, l'amplificateur opérationnel $A_1$ est connecté à la cathode de la diode à capacité variable D par l'intermédiaire d'une résistance $R_5$. Avec le circuit ci-dessus, la tension $V_S$ en sortie de l'amplificateur opérationnel $A_1$, est donnée par l'équation suivante :

$$V_S = V_C (1 + \frac{R_4}{R_2 + R_1} + \frac{R_4}{R_3}) - V_A \frac{R_4}{R_3}$$

D'autre part, la tension de recalage est en général obtenue en faisant varier la résistance $R_1$ qui est une résistance extérieure au système et dont la variation est fixée pour un système donné.

Avec le circuit ci-dessus, la valeur des résistances sera calculée de manière itérative de façon à ajuster le gain en fonction de la correction que l'on veut appliquer. En effet, dans les oscillateurs compensés en température, on s'impose un décalage de fréquence permettant de recaler le produit pendant plusieurs années. Ainsi, les valeurs des résistances $R_2$, $R_3$, $R_4$ seront calculées à partir des équations suivantes :

- à 25° et à la fréquence nominale F0, nous avons :

$$V_{S1} = V_{C1} (1 + \frac{R_4}{R_2 + R_1} + \frac{R_4}{R_3}) - V_A \frac{R_4}{R_3}$$

Après recalage $V_{S1} \rightarrow V_{S2}$ avec l'équation suivante :

$$V_{S2} = V_{C1} (1 + \frac{R_4}{R_2 + R'_1} + \frac{R_4}{R_3}) - V_A \frac{R_4}{R_3}$$

dans laquelle $R'_1$ est la valeur de la résistance $R_1$ après recalage.

D'autre part, une simple observation de la courbe de dérive du résonateur en fonction de la température et de la courbe de rotation de la compensation avec recalage (voir figure 3) montre que les maximums correspondent aux points d'inversion du résonateur. On peut donc utiliser comme point d'étalonnage, les points d'inversion du résonateur. Ceci donne un autre couple d'équations représentatif de la tension nécessaire à la température considérée.

- au point d'inversion et à la fréquence nominale F0, on a l'équation suivante :

$$V_{S3} = V_{C2} (1 + \frac{R_4}{R_2 + R_1} + \frac{R_4}{R_3}) - V_A \frac{R_4}{R_3}$$

et

- au point d'inversion et après recalage ($V_{S3} \rightarrow V_{S4}$) on a l'équation suivante :

$$V_{S4} = V_{C2} (1 + \frac{R_4}{R_2 + R'_1} + \frac{R_4}{R_3}) - V_A \frac{R_4}{R_3}$$

Comme la valeur de $R_1$ et sa variation $R'_1$ sont imposées, il suffit de résoudre ce système de quatre équations donnant en sortie les tensions $V_{S1}$, $V_{S2}$, $V_{S3}$ et $V_{S4}$ dans les configurations données pour obtenir les valeurs de $R_2$, $R_3$ et $R_4$. Les tensions $V_{S1}$ et $V_{S3}$ sont les tensions nécessaires pour obtenir la fréquence nominale F0 tandis que les tensions $V_{S2}$ et $V_{S4}$ sont les tensions donnant le même décalage de fréquence.

Avec le circuit décrit ci-dessus, on obtient la courbe de variation de fréquence en fonction de la température représentée à la figure 5. On observe sur cette courbe que la fréquence F0 évolue de manière sensiblement identique même après recalage.

**Revendications**

1. Oscillateur piézoélectrique compensé en température comportant :
   - un circuit oscillant constitué d'un amplificateur (A) dont la sortie est rebouclée sur l'entrée a travers un cristal piézoélectrique (P) monté en série avec un élément à capacité variable (D),
   - un circuit (CT) de régulation de la fréquence en fonction de la température délivrant une tension de compensation, connecté sur une première entrée d'un amplificateur (A1) opérationnel à résistance de contre-réaction (R4) ayant un gain variable au moyen d'une résistance réglable (R1), la sortie de l'amplificateur opérationnel (A1) étant connectée sur l'une des bornes de l'élément à capacité variable (D), caractérisé en ce que l'amplificateur opérationnel (A1) reçoit sur une deuxième entrée une tension de recalage délivrée par un circuit de rattrapage en fréquence (R1,R2,R3) comportant la résistance réglable (R1), le réglage de la résistance réglable (R1) modifiant d'une part la tension de recalage et d'autre part le gain de l'amplificateur opérationnel de manière à réduire l'évolution de la fréquence de l'oscillateur engendrée par son vieillissement.

2. Oscillateur selon la revendication 1, caractérisé en ce que l'amplificateur opérationnel (A1) reçoit sur son entrée non-inverseuse la tension de compensation et sur son entrée inverseuse la tension de recalage.

3. Oscillateur selon l'une des revendications 1 ou 2, caractérisé en ce que la résistance réglable (R1) est montée dans un pont de résistances (R2,R3) fonctionnant en diviseur.

4. Oscillateur selon la revendication 3, caractérisé en ce que le pont de résistances (R1, R2,R3) est connecté entre une source de tension ($V_A$) et une masse.

**Patentansprüche**

1. Temperaturkompensierter piezoelektrischer Oszillator,
   - mit einem von einem Verstärker (A) gebildeten Schwingkreis, dessen Ausgang an den Eingang über einen piezoelektrischen Kristall (P) in Reihe mit einem Element variabler Kapazität (D) rückgeschleift ist,
   - mit einer Schaltung (CT) zur Regelung der Frequenz abhängig von der Temperatur, wobei diese Schaltung eine Kompensationsspannung liefert und an einen ersten Eingang eines Operationsverstärkers ($A_1$) mit ohm'scher Gegenkopplung ($R_4$) und einem über einen regelbaren Widerstand ($R_1$) variablen Verstärkungsgrad angeschlossen ist, und wobei der Ausgang des Operationsverstärkers ($A_1$) an eine der Klemmen des Elements (D) mit variabler Kapazität angeschlossen ist, dadurch gekennzeichnet, daß der Operationsverstärker ($A_1$) an einem zweiten Eingang eine Nachstimmspannung empfängt, die von einer Frequenznachstimmungsschaltung ($R_1$, $R_2$, $R_3$) geliefert wird, die einen regelbaren Widerstand ($R_1$) enthält, wobei die Regelung des regelbaren Widerstands ($R_1$) einerseits die Nachstimmspannung und andererseits den Verstärkungsgrad des Operationsverstärkers so verändert, daß die Frequenzveränderung aufgrund der Alterung des Oszillators verringert wird.

2. Oszillator nach Anspruch 1, dadurch gekennzeichnet, daß der Operationsverstärker ($A_1$) an seinem nicht-invertierenden Eingang die Kompensationsspannung und an seinem invertierenden Eingang die Nachstimmspannung zugeführt erhält.

3. Oszillator nach einem der Ansprüche 1 und 2, dadurch gekennzeichnet, daß der regelbare Widerstand ($R_1$) in einem ohm'schen Spannungsteiler zusammen mit Widerständen ($R_2$, $R_3$) geschaltet ist.

4. Oszillator nach Anspruch 3, dadurch gekennzeichnet, daß der ohm'sche Spannungsteiler ($R_1$, $R_2$, $R_3$) zwischen eine Spannungsquelle ($V_A$) und Masse geschaltet ist.

**Claims**

1. Temperature-compensated piezoelectric oscillator including:
   - an oscillating circuit consisting of an amplifier (A), the output of which is looped back to the input through a piezoelectric crystal (P) mounted in series with a variable-capacitance element (D),
- a circuit (CT) for regulating the frequency as a function of the temperature which delivers a compensation voltage and is connected up to a first input of an operational amplifier (A1) with negative-feedback resistor (R4) having a gain which can be varied by means of an adjustable resistor (R1), the output of the operational amplifier (A1) being connected up to one of the terminals of the variable-capacitance element (D), characterized in that the operational amplifier (A1) receives on a second input a resetting voltage delivered by a frequency-correcting circuit (R1,R2,R3) containing the adjustable resistor (R1), the adjusting of the adjustable resistor (R1) modifying on the one hand the resetting voltage and on the other hand the gain of the operational amplifier in such a way as to lessen the alteration in the frequency of the oscillator, engendered by its ageing.

2. Oscillator according to Claim 1, characterized in that the operational amplifier (A1) receives the compensation voltage on its non-inverting input and the resetting voltage on its inverting input.

3. Oscillator according to one of Claims 1 or 2, characterized in that the adjustable resistor (R1) is mounted in a resistor bridge (R2,R3) operating as a divider.

4. Oscillator according to Claim 3, characterized in that the resistor bridge (R1,R2,R3) is connected up between a voltage source ($V_A$) and an earth.

# FIG.1

# FIG. 2 A

Polarisation après recalage

Polarisation à To

# FIG.2B

F

Po (à To)

P1 (Après recalage)

U

# FIG.2C

ΔC %

+30
+20
+10
0
-10
+2
+1
0
-1

0v
5v
1v
2v
4v

10v
20v
50v
100v

-60  -20 0 20  60   100   140   T°C

# FIG.3

# FIG.4

# FIG.5